# EUROPEAN PATENT APPLICATION

(11) **EP 2 463 917 A1**
(43) Date of publication of application: **13.06.2012**
(21) Application number: 10806233.2
(22) Date of filing: 04.08.2010
(51) Int. Cl.: H01L 31/042, C08K 3/26, C08L 23/08

(54) **RESIN COMPOSITION FOR SOLAR CELL-SEALING MATERIAL**

(30) Priority: 07.08.2009 JP 2009185273; 15.01.2010 JP 2010006380; 09.06.2010 JP 2010131566; 09.06.2010 JP 2010131567
(71) Applicant: Toyo Ink SC Holdings Co., Ltd., Tokyo 104-8377 (JP); Toyochem Co., Ltd., Tokyo 104-8379 (JP)
(72) Inventor: MASUKO, Keisuke, Tokyo 104-8379 (JP); FUKUDOME, Yasuhiro, Tokyo 104-8379 (JP); ONODA, Yusuke, Tokyo 104-8379 (JP); SAWADA, Seiji, Tokyo 104-8379 (JP); OOI, Satoshi, Tokyo 104-8379 (JP); TAKAHASHI, Hideki, Tokyo 104-8379 (JP)
(74) Representative: Ahner, Francis
(86) International application number: PCT/JP2010/004913
(87) International publication number: WO 2011/016233

(57) **Abstract**

To achieve improvement in initial conversion efficiency of solar cell modules, inhibition of deterioration in transparency of a resin, inhibition of degradation in adhesive properties with respect to a protective member over time, and inhibition of degradation in conversion efficiency. A resin composition for solar cell-sealing material according to the present invention includes an ethylene copolymer, and further includes at least one of: (i) a compound represented by the following general formula (1); (ii) a calcined product of the (i); (iii) a compound represented by the following general formula (2); and (iv) a calcined product of the (iii). The (i) has an average plate surface diameter of 0.01 to 0.9 µm and a refractive index of 1.45 to 1.55, and the (iii) has an average plate surface diameter of 0.02 to 0.9 µm and a refractive index of 1.48 to 1.6. General formula (1): Mg₁₋ₐ·Alₐ(OH)₂·Anⁿ⁻_{a/n}·bH₂O (0.2≤a≤0.35, 0≤b≤1, An: an n-valent anion); General formula (2): (M_{c}Mg_{1-c})_{1-d}·Al_{d}(OH)₂·Bₘ^{m-}d/m·eH₂O
(M represents a metal selected from the group consisting of Ni, Zn, and Ca; c, d, and e are respectively expressed as 0.2≤c≤1, 0.2≤d≤0.4, and 0≤e≤4; Bm: an m-valent anion).

## Description

### Technical Field

The present invention relates to a resin composition for solar cell-sealing material for use as a solar cell-sealing material.

### Background Art

In recent years, there are social demands for practical application, introduction, and enlargement of inexhaustible, clean solar power generation systems from the viewpoints of policies for withdrawal from nuclear power generation, countermeasures against soaring crude oil price, exhaustion of fossil fuels, and global environmental protection. Major solar power generation systems recently introduced are composed of silicon-based solar cell modules made of crystalline silicon, amorphous silicon, or the like, and peripheral devices. One of the greatest challenges is to reduce costs of introducing a large number of solar power generation systems. In recent years, the costs have been considerably reduced compared to conventional systems, but the costs of power generation at present are still higher than those of other energies. Under such circumstances, there is a demand for technological development for achieving a higher efficiency , a longer life, or the like of solar cells.

Meanwhile, in order to achieve a higher efficiency and a longer life of each solar cell module, it is necessary to improve various performances such as light receiving properties, transparency, weather resistance, water resistance, adhesion properties, corrosion resistance, and heat resistance. Then, sealing materials for protecting electricity generating elements against environments also require these performances (see Patent Literatures 1, 2, 3, and 4).
For this reason, ethylene-vinyl acetate copolymers having high transparency and high water resistance are often used as sealing materials. However, ethylene-vinyl acetate copolymers have drawbacks as follows. That is, deterioration in transparency, corrosion of metal interconnections, and degradation in adhesive properties with respect to a protective member are caused by acid generated due to deterioration by heat, water, or the like, or caused by moisture entering the modules, which leads to a degradation in conversion efficiency.

In this regard, Patent Literatures 5 and 6 disclose a transparent film in which acid acceptor particles having an average grain diameter of 5 µm or less are dispersed in ethylene-vinyl acetate copolymer, thereby reducing acid. Additionally, Patent Literature 7 discloses that acid can be reduced by the use of an acid acceptor made of magnesium hydroxide and having an average grain diameter of 0.01 to 10 µm in a solar cell sealing film.

### Citation List

### Patent Literature

[Patent Literature 1] Japanese Unexamined Patent Application Publication No. 08-148708
[Patent Literature 2] Japanese Unexamined Patent Application Publication No. 2000-183382
[Patent Literature 3] Japanese Unexamined Patent Application Publication No. 2005-126708
[Patent Literature 4] Japanese Unexamined Patent Application Publication No. 2008-53379
[Patent Literature 5] Japanese Unexamined Patent Application Publication No. 2005-29588
[Patent Literature 6] Japanese Unexamined Patent Application Publication No. 2008-115344
[Patent Literature 7] Japanese Unexamined Patent Application Publication No. 2009-40951

### Summary of Invention

### Technical Problem

In Patent Literatures 5 and 6, however, a refractive index difference between resin and the acid acceptor is large, which causes light scattering at an interface between the resin and the acid acceptor. This results in insufficient transparency. Further, since the disclosed grain diameter is large, sufficient effects of the acid acceptor cannot be obtained. This leads to degradation in adhesive properties with respect to a protective member over time and considerable degradation in conversion efficiency. In Patent Literature 7, the transparency is maintained because the refractive index difference between the resin and the acid acceptor is small. However, the catalytic activity of magnesium hydroxide is high, which promotes hydrolysis of ethylene-vinyl acetate copolymer. Accordingly, an acid accepting effect can be obtained, but the amount of generated acid increases and the molecular mass decreases. This causes deterioration in physical properties of ethylene-vinyl acetate copolymers. As a result, a higher efficiency and a longer life cannot be achieved.

It is an object of the present invention to provide a resin composition for solar cell-sealing material and a solar cell-sealing material which are capable of improving the initial conversion efficiency of solar cell modules, and suppressing degradation in transparency of a resin, and inhibiting degradation in adhesive properties with respect to a protective member over time and degradation in conversion efficiency by trapping acid generated due to resin deterioration or by trapping water entering into the solar cell modules.

### Solution to Problem

A first invention relates to a resin composition for solar cell-sealing material including an ethylene copolymer (A), the resin composition including at least one of:
(i) a laminar composite metal compound represented by the following general formula (1);
(ii) a calcined product of the laminar composite metal compound represented by the general formula (1);
(iii) a laminar composite metal compound represented by the following general formula (2); and .
(iv) a calcined product of the laminar composite metal compound represented by the general formula (2), in which
the (i) has an average plate surface diameter of 0.01 µm to 0.9 µm and a refractive index of 1.45 to 1.55, and
the (iii) has an average plate surface diameter of 0.02 µm to 0.9 µm and a refractive index of 1.48 to 1.6,

the general formula (1): Mg₁₋ₐ·Alₐ(OH)₂·Anⁿ⁻_{a/n}·bH₂O

(0.2≤a≤0.35, 0≤b≤1, An: an n-valent anion),

the general formula (2): (M_{c}Mg_{1-c})_{1-d}·Al_{d}(OH)₂·Bm^{m-}_{d/m}·eH₂O

(M represents a metal selected from the group consisting of Ni, Zn, and Ca; c, d, and e are respectively expressed as 0.2≤c≤1, 0.2≤d≤0.4, and 0≤e≤4; Bm: an m-valent anion).

A second invention relates to the resin composition for solar cell-sealing material of the above-described invention in which each of the (i) to (iv) has an acetic acid adsorption of 0.1 µmol/g to 0.8 µmol/g.

A third invention relates to the resin composition for solar cell-sealing material of the above-described invention in which the (ii) is a calcined product obtained by performing heat treatment on the (i) in a temperature range of 200°C to 800°C, and the (iv) is a calcined product obtained by performing heat treatment on the (iii) in a temperature range of 200°C to 800°C.

A fourth invention relates to the resin composition for solar cell-sealing material of the above-described invention in which 0.01 parts by weight to 20 parts by weight of at least one compound selected from the group consisting of the (i) to (iv) are used for 100 parts by weight of the ethylene copolymer (A).

A fifth invention relates to the resin composition for solar cell-sealing material of the above-described invention in which a time period required for the (i) to reach 80% of an equilibrium adsorption under an environment of 23°C and 50% RH is 120 minutes or less.

A sixth invention relates to the resin composition for solar cell-sealing material of the above-described invention in which the (ii) has a refractive index of 1.59 to 1.69, and a water absorption rate of 10% to 85% under an environment of 23°C and 50% RH in a stationary state for 2000 hours.

A seventh invention relates to the resin composition for solar cell-sealing material of the above-described invention in which the (i) has a BET specific surface area of 5 m²/g to 200 m²/g.

An eighth invention relates to the resin composition for solar cell-sealing material according to the invention in which the (iv) has an average plate surface diameter of 0.02 µm to 0.9 µm and a refractive index of 1.58 to 1.72.

A ninth invention relates to the resin composition for solar cell-sealing material of the above-described invention in which the ethylene copolymer (A) is at least one copolymer selected from the group consisting of an ethylene-vinyl acetate copolymer, an ethylene-methyl acrylate copolymer, an ethylene-ethyl acrylate copolymer, an ethylene-methyl methacrylate copolymer, and an ethylene-ethyl methacrylate copolymer.

A tenth invention relates to a masterbatch including the resin composition for solar cell-sealing material of the above-described invention.

An eleventh invention relates to a solar cell-sealing material including a mixture including the resin composition for solar cell-sealing material of the above-described invention.

A twelfth invention relates to a solar cell module including the resin composition for solar cell-sealing material of the above-described invention.

### Advantageous Effects of Invention

According to the present invention, it is possible to provide a resin composition for solar cell-sealing material which enables formation of a solar cell-sealing material capable of improving an initial conversion efficiency, providing excellent transparency, suppressing resin deterioration due to a catalytic activity of a filler, and inhibiting degradation in adhesive properties with respect to a protective member over time and degradation in conversion efficiency by trapping acid or water, and it is also possible to provide a solar cell-sealing material.

### Brief Description of Drawings

Fig. 1 is a schematic explanatory diagram showing an example of a solar cell module sample;
Fig. 2 is an explanatory diagram showing a sample for durability test;
Fig. 3 is an explanatory diagram showing a sample for durability test; and
Fig. 4 is an explanatory diagram showing a sample for durability test.

### Description of Embodiments

First, the present invention will be described in detail. Herein, the phrases "equal to or greater than an arbitrary number A, and equal to or smaller than an arbitrary number B" and "an arbitrary number A to an arbitrary number B" refer to a range equal to or greater than the number A and a range equal to or smaller than the number B. A resin composition for solar cell-sealing material according to the present invention includes an ethylene copolymer (A), and further includes at least one of (i) to (iv) as described below:
(i) a laminar composite metal compound represented by the following general formula (1);
(ii) a calcined product of the laminar composite metal compound represented by the general formula (1);
(iii) a laminar composite metal compound represented by the following general formula (2); and
(iv) a calcined product of the laminar composite metal compound represented by the general formula (2),

the general formula (1): Mg₁₋ₐ·Alₐ(OH)₂·Anⁿ⁻_{a/n}·bH₂O

(0.2≤a≤0.35, 0≤b≤1, An: an n-valent anion),

the general formula (2): (McMg_{1-c})_{1-d}·Al_{d}(OH)₂·Bm^{m-}_{d/m}eH₂O

(M represents a metal selected from the group consisting of Ni, Zn, and Ca; c, d, and e are respectively expressed as 0.2≤c≤1, 0.2≤d≤0.4, and 0≤e≤4; Bm: an m-valent anion).

The (i) has an average plate surface diameter of 0.01 µm to 0.9 µm and a refractive index of 1.45 to 1.55. The (iii) has an average plate surface diameter of 0.02 µm to 0.9 µm and a refractive index of 1.48 to 1.6.

The (i) is a hydrotalcite-based compound, which is a laminar compound having an interlayer ion-exchange property and neutralization reactivity with acid. The (iii) is also a laminar compound having an interlayer ion exchange property and neutralization reactivity with acid. The term "interlayer ion exchange property" herein described refers to a property of replacing anions existing between the layers of the laminar composite metal compound with other anions. The presence or absence of replacement of anions depends on the density of ion charges. The use of the (i) and/or the (iii) for a solar cell module allows water entering a solar cell-sealing material or acid generated by hydrolysis of an ethylene copolymer to be trapped in the layers. Further, the acid trapped in the layers is neutralized, thereby providing an effect of preventing deterioration of the solar cell-sealing material or electricity generating elements (the effect is hereinafter referred to also as "acid/water trapping effects").

The acid/water trapping effects is determined depending on the density of ion charges to be trapped in the layers. Anions having a greater valence and a smaller ion diameter are more likely to be trapped in the layers. Furthermore, a laminar composite metal compound having a higher basicity exhibits a higher neutralization reactivity. However, this accelerates the hydrolysis of ethylene copolymers. Thus, it has been found, from the relationship between the neutralization and the hydrolysis, that a certain range of basicity provides the highest acid trapping effect.

Not only the laminar composite metal compound, but also a metal oxide, a metal hydroxide, a metal carbonate compound, and the like are known as compounds having the acid/water trapping effects. Many of these compounds have a high refractive index. Accordingly, if these compounds are added to an ethylene copolymer, a refractive index difference between each compound and the ethylene copolymer increases, which causes light scattering and reflection, resulting in opacity and lowered conversion efficiency. A catalytic activity of a filler accelerates the hydrolysis of ethylene copolymer, which results in degradation in physical properties of a resin, degradation in generation efficiency, and a shorter life.

In this regard, the use of a metal compound such as a metal oxide typically lowers the initial conversion efficiency of solar cells. On the other hand, according to the present invention, it has been found that the use of a specific laminar composite metal compound or a calcined product of the compound provides an extraordinary effect of improving the initial conversion efficiency. Moreover, it has been found that the use of a specific laminar composite metal compound or a calcined product of the compound provides an advantageous effect of improving the transparency and the acid/water trapping effects, and inhibiting degradation in adhesive properties with respect to a protective member over time and degradation in conversion efficiency.

In the present invention, the calcined product (ii) can be produced by calcinating the laminar composite metal compound (i) represented by the general formula (1). The calcined product (ii) exhibits higher acid/water trapping effects than those of the laminar composite metal compound represented by the general formula (1) obtained before the calcination. In the present invention, the calcined product (iv) can be produced by calcinating the laminar composite metal compound (iii) represented by the general formula (2). The calcined product (iv) exhibits higher acid/water trapping effects than those of the laminar composite metal represented by the general formula (2) obtained before the calcination. Further, it has been found that in the calcined products (ii) and (iv), trapping of acid or water allows a change in chemical composition, reduction in refractive index, and reduction in refractive index difference between each calcined product and the ethylene copolymer (A). That is, the transparency is improved over time.

In the above general formula (1), it is important that the content "a" of Al be set in the range of 0.2≤a≤0.35. If the content "a" is less than 0.2, it is difficult to produce the laminar composite metal compound. If the content "a" exceeds 0.35, the refractive index difference between the compound and the ethylene copolymer (A) increases, resulting in deterioration of the transparency. The moisture content "b" is preferably set in the range of 0≤b≤1.
In the above general formula (2), the content "c" of Al is preferably set in the range of 0.2≤c≤0.4. If the content "c" is less than 0.2, it is difficult to produce the laminar composite metal compound. If the content "c" exceeds 0.4, it is difficult to produce the laminar composite metal compound, because repulsive forces of positive charges between metals are extremely large. The moisture content "d" is preferably set in the range of 0≤d≤4.
The type of anion Anⁿ⁻ in the general formulas (1) and (2) is not particularly limited. Examples of anion Anⁿ⁻ include hydride ion, carbonate ion, silicate ion, organic carboxylic acid ion, organic sulfonic acid ion, and organic phosphate ion. Note that the index "a" in the general formula (1) and the index "c" in the general formula (2) were obtained by dissolving each laminar composite metal compound with acid and analyzing the resultant using "plasma emission spectrometer SPS4000 (Seiko Denshi Kogyo Co., Ltd.)".

It is important that the compound (i) have an average plate surface diameter of 0.01 to 0.9 µm, preferably 0.02 to 0.75 µm in terms of the acid/water supplementary effects, and more preferably 0.02 to 0.65 µm. If the average plate surface diameter exceeds 0.9 µm, the acid/water trapping effects are insufficient. If the average plate surface diameter is less than 0.01 µm, it is difficult to industrially produce the laminar composite metal compound. The average plate surface diameter of the laminar composite metal compound is expressed by an average value of the values obtained by measurement from electron photomicrographs.

It is important that the compound (iii) have an average plate surface diameter of 0.02 to 0.9 µm, and preferably 0.02 to 0.65 µm in terms of the dispersion properties and transparency. If the average plate surface diameter exceeds 0.9 µm, the acid trapping ability is insufficient when the compound is blended with the ethylene copolymer (A). If the average plate surface diameter is less than 0.02 µm, it is difficult to industrially produce the laminar composite metal compound.

It is important that the compound (i) have a refractive index ranging from 1.45 to 1.55, and preferably 1.47 to 1.53 in terms of the transparency depending on a refractive index difference between the compound and a resin and the acid/water trapping effects. If the refractive index is less than 1.45, it is difficult to industrially produce the laminar composite metal compound. If the refractive index exceeds 1.55, the transparency is insufficient when the compound is blended with the ethylene copolymer (A). Accordingly, it is necessary to reduce the blending quantities. This results in a reduction in persistence of the acid/water trapping effects. Note that the refractive index was measured based on JIS K0062. Specifically, the refractive index was measured using α-bromonaphthalene and DMF as solvent at 23°C by Becke method using "Abbe refractometer: 3T (manufactured by Atago Co., Ltd.)".

It is important that the compound (iii) have a refractive index ranging from 1.48 to 1.6, and preferably 1.48 to 1.55 in terms of the transparency due to the refractive index difference between the compound and the resin. If the refractive index of is less than 1.48, it is difficult to industrially produce the laminar composite metal compound. On the other hand, if the refractive index exceeds 1.6, the transparency is insufficient when the compound is blended with the ethylene copolymer (A). Accordingly, it is necessary to reduce the blending quantities. This results in a reduction in persistence of the acid/water trapping effects.

In the general formula (1), the efficiency of neutralization reaction varies depending on the size of the BET specific surface area. It has been found that a larger BET specific surface area provides a higher supplementary efficiency. The compound (i) preferably has a BET specific surface area of 5 to 200 m²/g, preferably 15 to 160 m²/g in terms of the acid/water trapping effects, and more preferably 35 to 100 m²/g. If the BET specific surface area is less than 15 m²/g, the neutralization efficiency may deteriorate, and the adhesive properties with respect to a protective member may be lowered due to resin deterioration. If the BET specific surface area exceeds 200 m²/g, the dispersion properties with ethylene copolymer (A) may deteriorate.

Each of the (i) to (iv) preferably has an acetic acid adsorption of 0.1 to 0.8 µmol/g. If the adsorption is less than 0.1 µmol, the acid supplementary ability may be insufficient. On the other hand, if the adsorption exceeds 0.8 µmol, the basicity is extremely large, which may accelerate the hydrolysis of the resin. The acetic acid adsorption was obtained in the following manner. That is, 30ml of ethylene glycol monomethyl ether solution including 0.02 mol/L of acetic acid is added to 1 g of the laminar composite metal compound, and the resultant was subjected to ultrasonic cleaning for one and a half hour. Then, the resultant was adsorbed to the laminar composite metal compound, and a supernatant liquid obtained as a result of centrifugal separation with a 0.1 normal potassium hydroxide solution was measured by a back titration method using potentiometric titration.

A time period required for the compound (i) to reach 80% of an equilibrium adsorption under an environment of 23°C and 50% RH is preferably 120 minutes or less. If the time period exceeds 120 minutes, a fast-acting property of the acid/water trapping effects is low, which may make it difficult to inhibit degradation in adhesive properties with respect to a protective member over time.

The equilibrium adsorption of the (i) is a value representing a ratio between an increase in weight and an original weight, which is expressed in percentage, when a specimen is held in a stationary state for 2000 hours under an environment of 23°C and 50% RH.

In the present invention, the calcined product (ii) preferably has a refractive index of 1.59 to 1.69. If the refractive index is less than 1.59, calcination is insufficient, so that a crystal defect is more likely to occur and the sealing material may deteriorate. If the refractive index exceeds 1.69, a refractive index difference between the calcined product (ii) and the ethylene copolymer (A) is large, which may result in insufficient transparency.

When the calcined product (ii) is held in a stationary state for 2000 hours under an environment of 23°C and 50% RH, the calcined product (ii) preferably has a water absorption rate of 10 to 85%, more preferably 30 to 85%, and further preferably 40 to 85%, in terms of the acid/water trapping effects. If the water absorption rate exceeds 85%, water absorption progresses when a resin composition for a solar cell is produced. This may result in an insufficient water trapping effect when the resin composition is formed into a module. If the water absorption rate is less than 10%, the acid/water trapping effects are low, which may make it difficult to inhibit degradation in adhesive properties with respect to a protective member over time.

The water absorption rate of the (ii) is a value representing a ratio between an increase in weight and an original weight, which is expressed in percentage, when the (ii) is held in a stationary state for 2000 hours under an environment of 23°C and 50% RH.

The calcined product (iv) preferably has an average plate surface diameter of 0.02 to 0.9 µm, and more preferably 0.02 to 0.65 µm in terms of the dispersion properties and transparency. If the average plate surface diameter exceeds 0.9 µm, the acid trapping ability may be insufficient when the calcined product (iv) is blended with the ethylene copolymer (A). If the average plate surface is less than 0.02 µm, it is difficult to industrially produce the laminar composite metal compound.

The (iv) preferably has a refractive index of 1.58 to 1.72. If the refractive index is less than 1.58, calcination is insufficient, so that a crystal defect is more likely to occur and the sealing material may deteriorate. If the refractive index exceeds 1.72, the transparency may be insufficient when the (iv) is blended with the ethylene copolymer (A).

Preferably, 0.01 to 20 parts by weight in total of the (i) to (iv) are used for 100 parts by weight of the ethylene copolymer (A). For example, in the case of producing a resin composition for solar cell-sealing material of a high concentration composition such as a masterbatch, 5 to 20 parts by weight of the (i) to (iv) are preferably used. It is preferable to produce the solar cell-sealing material using a masterbatch, in terms of dispersion and handling of the laminar composite metal compound. Meanwhile, in the case of producing a resin composition for solar cell-sealing material other than a masterbatch, for example, 0.01 to 7 parts by weight of the (i) or (iii) are preferably used in terms of transparency. Further, 0.01 to 5 parts by weight of the (ii) or (iv) are preferably used. If the usage exceeds an upper limit, the transparency is insufficient, which may result in deterioration of the initial conversion efficiency. If less than 0.01 parts by weight are used, the acid/water trapping effects may be insufficient.

In the case of combining the (iii) and (iv), 0.01 to 15 parts by weight are preferably used for 100 parts by weight of the ethylene copolymer (A). In the case of combining the (i) and (iii), 0.01 to 7 parts by weight in total are preferably used. In the case of combining the (i) and (iv), 0.01 to 5 parts by weight of the (i) and 0.01 to 3 parts by weight of the (iv) are preferably used. In the case of combining the (i), (iii), and (iv), 0.01 to 5 parts by weight in total of the (i) and (iii), and 0.01 to 3 parts by weight of the (iv) are preferably used. In the case of combining the (ii) and (iii), 0.01 to 3 parts by weight of the (ii) and 0.01 to 5 parts by weight of the (iii) are preferably used. In the case of combining the (ii) and (iv), 0.01 to 5 parts by weight in total are preferably used. In the case of combining (ii), (iii), and (iv), 0.01 to 3 parts by weight in total of the (ii) and (iv) and 0.01 to 5 parts by weight of the (iii) are preferably used.

Next, a method for producing the (i), i.e., the laminar composite metal compound represented by the general formula (1) will be described.

The laminar composite metal compound represented by the general formula (1) is obtained in the following manner. That is, an alkaline aqueous solution containing an anion, a magnesium salt aqueous solution, and an aluminum salt aqueous solution are mixed to prepare a mixed solution having pH in the range of 10 to 14. Then, the mixed solution is matured in the temperature range of 80 to 100°C.

The PH in the maturation reaction is preferably 10 to 14, and more preferably 11 to 14. If the pH is less than 10, the plate surface diameter is large, which may make it difficult to obtain a laminar composite metal compound having an appropriate thickness.

If the maturing temperature is lower than 80°C or exceeds 100°C, it is difficult to obtain a laminar composite metal compound having an appropriate plate surface diameter. More preferably, the maturing temperature ranges from 85 to 100°C.

An aging time in the maturation reaction of the laminar composite metal compound is not particularly limited, but is about 2 to 24 hours, for example. If the aging time is less than two hours, the average plate surface diameter is large, which makes it difficult to obtain a laminar composite metal compound having an appropriate thickness. If the aging time exceeds 24 hours, the maturation is not cost effective.

Preferable examples of alkaline aqueous solution containing an anion include a mixed alkali aqueous solution of an aqueous solution containing an anion and an alkali hydroxide aqueous solution.

Preferable examples of the aqueous solution containing an anion include aqueous solutions of sodium carbonate, calcium carbonate, sodium phosphate, sodium silicate, organic carboxylic acid salt, organic sulfonic acid salt, and organic phosphate.

Preferable examples of the alkali hydroxide aqueous solution include aqueous solutions of sodium hydroxide, potassium hydroxide, ammonia, and urea.

Examples of the magnesium salt aqueous solution used in the present invention include a magnesium sulfate aqueous solution, a magnesium chloride aqueous solution, and a magnesium nitrate aqueous solution. Preferably, a magnesium sulfate aqueous solution or a magnesium chloride aqueous solution is used. Alternatively, a slurry containing magnesium oxide powder or magnesium hydroxide powder may also be used.

Examples of the aluminum salt aqueous solution used in the present invention include an aluminum sulfate aqueous solution, an aluminum chloride aqueous solution, and an aluminum nitrate aqueous solution. Preferably, an aluminum sulfate aqueous solution or an aluminum chloride aqueous solution is used. Alternatively, a slurry containing aluminum oxide powder or aluminum hydroxide powder may also be used.

The mixing order of the alkali aqueous solution containing an anion, magnesium, and aluminum is not particularly limited. Each aqueous solution or slurry may be mixed simultaneously. Preferably, an aqueous solution or slurry prepared by mixing therein magnesium and aluminum is added to the alkali aqueous solution containing an anion.

In the case of adding each aqueous solution, the aqueous solution may be added at one time or may be continuously dropped.

The pH of the (i) is preferably 8.5 to 10.5. If the pH is less than 8.5, the efficiency of neutralization with acid may be reduced. If the pH exceeds 10.5, the ethylene copolymer may deteriorate due to elution of magnesium. The pH of the laminar composite metal compound was measured in the following manner. That is, 5 g of specimen was measured and put into a conical flask of 300 ml, and 100 ml of boiling pure water was added and heated. Then, the boiling state was kept for about five minutes, and the flask was closed with a stopper and cooled to a room temperature. Further, an amount of water corresponding to a reduced amount of water was added, and the flask was closed with the stopper again and was shaken for one minute. Then, the flask was held in a stationary state for five minutes. After that, the pH of a supernatant thus obtained was measured according to JIS Z8802-7. The obtained value was determined as the pH of the laminar composite metal compound.

The (ii) is preferably a calcined product obtained by performing heat treatment on the (i), which is the laminar composite metal compound represented by the general formula (1), in the temperature range of 200 to 800°C for 1 to 24 hours. The heat treatment is preferably performed in the temperature range of 250°C to 700°C. The time period for the heat treatment may be adjusted depending on the temperature for the heat treatment. The heat treatment may be performed in an oxidizing atmosphere or a non-oxidation atmosphere. However, it is preferable not to use a gas having a strong reducing action, such as hydrogen.

Next, a method for producing the (iii), i.e., the laminar composite metal compound represented by the general formula (2) will be described.

The laminar composite metal compound represented by the general formula (2) can be obtained in the following manner. That is, at least one of a magnesium salt aqueous solution, a zinc salt aqueous solution, a nickel salt aqueous solution, and a calcium salt aqueous solution, an alkaline aqueous solution containing an anion, and an aluminum salt aqueous solution are mixed to prepare a mixed solution having pH in the range of 8 to 14. Then, the mixed solution is matured in the temperature range of 80 to 100°C.

The pH in the maturation reaction is preferably 10 to 14, and more preferably 11 to 14. If the pH is less than 10, the plate surface diameter is large, which may make it difficult to obtain a laminar composite metal compound having an appropriate thickness.

If the maturing temperature is lower than 80°C or exceeds 100°C, it is difficult to obtain a laminar composite metal compound having an appropriate plate surface diameter. More preferably, the maturing temperature ranges from 85 to 100°C.

The aging time in the maturation reaction of the laminar composite metal compound is not particularly limited, but is about 2 to 24 hours, for example. If the aging time is less than two hours, the plate surface diameter is large, which makes it difficult to obtain a laminar composite metal compound having an appropriate thickness. If the aging time exceeds 24 hours, the maturation is not cost effective.

The examples described in the method for producing the (i) may be used as preferable examples of the alkaline aqueous solution containing an anion, the aqueous solution containing an anion, and the alkali hydroxide aqueous solution.

Examples of metallic salt aqueous solutions used in the present invention include a metal sulfate aqueous solution, a metal chloride aqueous solution, and a metal nitrate aqueous solution. Preferably, a magnesium chloride aqueous solution is used. Alternatively, a slurry containing metal oxide powder or metal hydroxide powder may also be used.

Examples of the aluminum salt aqueous solution used in the present invention include an aluminum sulfate aqueous solution, an aluminum chloride aqueous solution, and an aluminum nitrate aqueous solution. Preferably, an aluminum chloride aqueous solution is used. Alternatively, a slurry containing aluminum oxide powder or aluminum hydroxide powder may also be used.

The mixing order of at least one of the alkali aqueous solution containing an anion, magnesium, zinc, nickel, and calcium, and aluminum is not particularly limited. Each aqueous solution or slurry may be simultaneously mixed. Preferably, an aqueous solution or slurry prepared by mixing magnesium, zinc, nickel, calcium, and aluminum is added to the alkali aqueous solution containing an anion.

In the case of adding each aqueous solution, the aqueous solution may be added at one time or may be continuously dropped.

The pH of the laminar composite metal compound represented by the general formula (2) is preferably 8 to 10. If the pH is less than 8, the efficiency of neutralization with acid may be reduced. If the pH exceeds 10, the ethylene-vinyl acetate copolymer may deteriorate due to elution of metal. The pH of the laminar composite metal compound was measured in the following manner. That is, 5 g of specimen was measured and put into a conical flask of 300 ml, and 100 ml of boiling pure water was added and heated. Then, the boiling state was kept for about five minutes, and the flask was closed with a stopper and cooled to a room temperature. Further, an amount of water corresponding to a reduced amount of water was added, and the flask was closed with the stopper again and was shaken for one minute. Then, the flask was held in a stationary state for five minutes. After that, the pH of a supernatant thus obtained was measured according to JIS Z8802-7. The obtained value was determined as the pH of the laminar composite metal compound.

The (iv) is preferably produced by performing heat treatment on the laminar composite metal compound in the temperature range of 200°C to 800°C, and more preferably 250°C to 700°C. The time period for the heat treatment may be adjusted depending on the temperature for the heat treatment. The time period is preferably 1 to 24 hours, and more preferably 2 to 10 hours. The heat treatment may be performed in an oxidizing atmosphere or a non-oxidation atmosphere. However, it is preferable not to use a gas having a strong reducing action, such as hydrogen.

From the viewpoints of reduction in damage on cells during a laminating process, transparency, and improvement in productivity, an ethylene-vinyl acetate copolymer having a vinyl acetate content of 15 to 40 weight % is preferably used as the ethylene copolymer (A) in the present invention. More preferably, an ethylene-vinyl acetate copolymer having a vinyl acetate content of 25 to 35 weight % is used.

The ethylene copolymer (A) used in the present invention is a copolymer obtained by mixing two or more types of monomers. The types of monomers are not particularly limited as long as at least one of the monomers is an ethylene monomer. Specific examples of the ethylene copolymer include an ethylene-vinyl acetate copolymer, an ethylene-methyl acrylate copolymer, an ethylene-ethyl acrylate copolymer, an ethylene-methyl methacrylate copolymer, an ethylene-ethyl methacrylate copolymer, ethylene-(vinyl acetate)-based multicomponent copolymer, ethylene-(methyl acrylate)-based multicomponent copolymer, ethylene-(ethyl acrylate)-based multicomponent copolymer, ethylene-(methyl methacrylate)-based multicomponent polymer, and ethylene-(ethyl methacrylate)-based multicomponent polymer. From the viewpoints of reduction in damage on cells during a laminating process, transparency, and improvement in productivity, an ethylene-vinyl acetate copolymer having a vinyl acetate content of 15 to 40% is preferably used. More preferably, an ethylene-vinyl acetate copolymer having a vinyl acetate content of 25 to 35% is used.
In the present invention, in view of the moldability, mechanical strength, and the like, the ethylene copolymer (A) preferably has a melt flow rate (compliant with JIS K7210) of 0.1 to 60 g/10 min, and more preferably 0.5 to 45 g/10 min. Note that the melt flow rate is hereinafter referred to as "MFR".

The resin composition for solar cell-sealing material according to the present invention can be produced in the following manner. That is, the ethylene copolymer (A) and at least one of the (i) to (iv) are mixed using a typical high speed shearing type mixer, such as a Henschel mixer or a super mixer, and are then melted and kneaded using a twin roll, a triple roll, a pressurizing kneader, a Banbury mixer, an uniaxial mixing extruder, a biaxial mixing extruder, or the like. After that, the resultant is extruded to be molded into a pellet shape or is kneaded to be processed into a sheet shape and then formed into a pellet shape.

The resin composition for solar cell-sealing material of the present invention thus obtained may be blended with additives such as crosslinkers, coagents, silane coupling agents, ultraviolet light absorbers, light stabilizers, antioxidants, light diffusing agents, wavelength converting agents, colorants, or flame retardants, as needed. Furthermore, various additives may be blended with ethylene copolymers and the laminar composite metal compound, or may be added separately during production of the finally molded material.

Crosslinkers are used to prevent thermal deformation of ethylene copolymers under high temperature use conditions. In the case of using ethylene copolymers, an organic peroxide is typically used. The addition amount is not particularly limited, but 0.05 to 3 parts by weight are preferably used for 100 parts by weight in total of the ethylene copolymer and at least one of the (i) to (iv). Specific examples include tert-butylperoxy isopropyl carbonate, tert-butylperoxy-2-ethylhexylisopropyl carbonate, tert-butylperoxyacetate, tert-butylcumyl peroxide, 2,5-dimethyl-2,5-di(tert-butylperoxy)hexane, di-tert-butyl peroxide, 2,5-dimethyl-2,5-di(tert-butylperoxy)hexyne-3, 2,5-dimethyl-2,5-di(tert-butylperoxy)hexane, 1,1-di(tert-hexylperoxy)-3,3,5-trimethylcyclohexane, 1,1-di(tert-butylperoxy)cyclohexane, 1,1-di(tert-hexyl peroxy)cyclohexane, 1,1-di(tert-amylperoxy)cyclohexane, 2,2-di(tert-butylperoxy)butane, methyl ethyl ketone peroxide, 2,5-dimethylhexyl-2,5-diperoxybenzoate, tert-butyl hydroperoxide, p-menthane hydroperoxide, dibenzoyl peroxide, p-chlorbenzoyl peroxide, tert-butylperoxyisobutyrate, n-butyl-4,4-di(tert-butylperoxy)valerate, ethyl-3,3-di(tert-butylperoxy)butyrate, hydroxyheptyl peroxide, cyclohexanone peroxide, 1,1-di(tert-butylperoxy)-3,3,5-trimethyl cyclohexane, n-butyl-4,4-di(tert-butylperoxy)valerate, and 2,2-di(tert-butylperoxy)butane.

Coagents are used to carry out cross-linking reaction efficiency. For example, polyunsaturated compounds such as polyallyl compounds and polyacryloyloxy compounds are used. The addition amount is not particularly limited, but 0.05 to 3 parts by weight are preferably used for 100 parts by weight in total of the ethylene copolymer and at least one of the (i) to (iv). Specific examples include triallyl isocyanurate, triallyl cyanurate, diallyl phthalate, diallyl phthalate, diallyl maleate, ethylene glycol diacrylate, ethylene glycol dimethacrylate, and trimethylol propane trimethacrylate.

Silane coupling agents are used to improve adhesive properties with respect to protection materials, solar cell elements, and the like. Examples of silane coupling agents include compounds having an unsaturated group such as a vinyl group, an acryloyloxy group, or a methacryloxy group, or a hydrolyzable group such as an alkoxy group. The addition amount is not particularly limited, but 0.05 to 3 parts by weight are preferably used for 100 parts by weight in total of the ethylene copolymer and at least one of the (i) to (iv). Specific examples include vinyltrichlorosilane, vinyl-tris(β-methoxyethoxy)silane, vinyltriethoxysilane, vinyltrimethoxysilane, γ-methacryloxypropyltrimethoxysilane, β-(3,4-epoxycyclohexyl)ethyltriethoxysilane, γ-glycidoxypropylmethyldimethoxysilane, N-β(aminoethyl)-γ-aminopropyltrimethoxysilane, N-β (aminoethyl)-γ-aminopropylmethyldimethoxysilane, γ-aminopropyltriethoxysilane, N-phenyl-γ-aminopropyltrimethoxysilane, γ-mercaptopropyltrimethoxysilane, and γ-chloropropyltrimethoxysilane.

Ultraviolet light absorbers are used to provide a weather resistance. Examples of ultraviolet light absorbers include benzophenone-based, benzotriazole-based, triazine-based, and salicylate ester-based absorbers. The addition amount is not particularly limited, but 0.01 to 3 parts by weight are preferably used for 100 parts by weight in total of the ethylene copolymer and the laminar composite metal compound. Specific examples include 2-hydroxy-4-methoxybenzophenone, 2-hydroxy-4-methoxy-2'-carboxybenzophenone, 2-hydroxy-4-octoxybenzophenone, 2-hydroxy-4-n-dodecyloxybenzophenone, 2-hydroxy-4-n-octadecyloxybenzophenone, 2-hydroxy-4-benzyloxybenzophenone, 2-hydroxy-4-methoxy-5-sulfobenzophenone, 2-hydroxy-5-chlorobenzophenone, 2,4-dihydroxybenzophenone, 2,2'-dihydroxy-4-methoxybenzophenone, 2,2'-dihydroxy-4,4'-dimethoxybenzophenone, 2,2',4,4'-tetrahydroxybenzophenone, 2-(2-hydroxy-5-methylphenyl)benzotriazole, 2-(2-hydroxy-5-t-butylphenyl)benzotriazole, 2-(2-hydroxy-3,5-dimethylphenyl)benzotriazole, 2-(2-methyl-4-hydroxyphenyl)benzotriazole, 2-(2-hydroxy-3-methyl-5-t-butylphenyl)benzotriazole, 2-(2-hydroxy-3,5-di-t-butylphenyl)benzotriazole, 2-(2-hydroxy-3, 5-dimethylphenyl)-5-methoxybenzotriazole, 2-(2-hydroxy-3-t-butyl-5-methylphenyl)-5-chlorobenzotriazole, 2-(2-hydroxy-5-t-butylphenyl)-5-chlorobenzotriazole, 2-[4,6-bis(2,4-dimethylphenyl)-1,3,5-triazine-2-yl]-5-(octyloxy)phenol, 2-(4,6-diphenyl-1,3,5-triazine-2-yl)-5-(hexyloxy)phenol, phenyl salicylate, and p-octylphenyl salicylate.

Light stabilizers are used in combination with ultraviolet light absorbers so as to provide a weather resistance. Examples of light stabilizers include a hindered amine light stabilizer. The addition amount is not particularly limited, but 0.01 to 3 parts by weight are preferably used for 100 parts by weight in total of the ethylene copolymer and at least one of the (i) to (iv). Specific examples include dimethyl succinate-1-(2-hydroxyethyl)-4-hydroxy-2,2,6,6-tetramethylpiperidine condensate, poly[{6-(1,1,3,3-tetramethylbutyl)amino-1,3,5-triazine-2,4-diyl}{(2,2,6,6-tetramethyl-4-pipcridyl)imino}hexamethylene{2,2,6,6-tetramethyl-4-piperidyl)imino}, N,N'-bis (3-aminopropyl)ethylenediamine-2,4-bis[N-butyl-N-(1,2,2,6,6-pentmethyl-4-piperidyl)amino]-6-chloro-1,3,5-triazine condensate, bis(2,2,6,6-tetramethyl-4-piperidyl)separate, and 2-(3,5-di-tert-4-hydroxybenzyl)-2-n-butylmalonic acid bis(1,2,2,6,6-pentmethyl-4-piperidyl).

Antioxidants are used to provide stability under high temperature. Examples of antioxidants include monophenol-based, bisphenol-based, polymeric phenol-based, sulfuric-based, and phosphite-based antioxidants. The addition amount is not particularly limited, but 0.05 to 3 parts by weight are preferably used for 100 parts by weight in total of the ethylene copolymer and at least one of the (i) to (iv). Specific examples of the antioxidant include 2,6-di-tert-butyl-p-cresol, butylated hydroxyanisole, 2,6-di-tert-butyl-4-ethylphenol, 2,2'-methylene-bis-(4-methyl-6-tert-butylphenol), 2,2'-methylene-bis-(4-ethyl-6-tert-butylphenol), 4,4'-thiobis-(3-methyl-6-tert-butylphenol), 4,4'-butylidene-bis-(3-methyl-6-tert-butylphenol), 3,9-bis[{1,1-dimethyl-2-{β-(3-tert-butyl-4-hydroxy-5-methylphenyl)propionyloxy}ethyl}-2,4,8,10-tetraoxaspiro]5,5-undecane, 1,1,3-tris-(2-methyl-4-hydroxy-5-tert-butylphenyl)butane, 1,3,5-trimethyl-2,4,6-tris(3,5-di-tert-butyl-4-hydroxybenzyl)benzene, tetrakis {methylene-3-(3',5'-di-tert-butyl-4'-hydroxyphenyl)propionate}methane, bis{(3,3'-bis-4'-hydroxy-3'-tert-butylphenyl)butyric acid}glycol ester, dilauryl thiodipropionate, dimyristyl thiodipropionate, distearyl thiopropionate, triphenyl phosphite, diphenylisodecyl phosphite, phenyldiisodecyl phosphite, 4,4'-butylidene-bis-(3-methyl-6-tert-butylphenyl-di-tridecyl)phosphite, cyclic neopentanetetrayl bis(octadecyl phosphite), tris(diphenylphosphite), di-isodecyl pentaerythritol diphosphite, 9,10-dihydro-9-oxa-10-phosphaphenanthrene-10-oxide, 10-(3,5-di-tert-butyl-4-hydroxybenzyl)-9,10-dihydro-9-oxa-10-phosphaphenanthrene-10-oxide, 10-desiloxy-9,10-dihydro-9-oxa-10-phosphaphenanthrene, cyclic neopentanetetrayl bis(2,4-di-tert-butylphenyl)phosphite, cyclic neopentanetetrayl bis(2,6-di-tert-methylphenyl)phosphite, and 2,2-methylenebis(4,6-tert-butylphenyl)octylphosphite.

Solar cell-sealing materials are typically produced by a molding method using a T-die extruder, a calendar molding machine, or the like. The solar cell-sealing material of the present invention can be obtained in the following manner. That is, a resin composition obtained by blending the ethylene copolymer (A) with at least one of the (i) to (iv) is prepared in advance. During formation of a sheet, a crosslinker, a coagent, a silane coupling agent, an ultraviolet light absorber, a light stabilizer, and an antioxidant are blended and extruded to be molded into a sheet shape using a T-die extruder at a molding temperature at which the crosslinker does not substantially decompose. The sealing material preferably has a thickness of about 0.1 to 1 mm.

Further, the solar cell-sealing material may be preferably produced in the following manner. That is, the resin composition for solar cell-sealing material is produced as a masterbatch including at least one of the (i) to (iv) at high concentration. The masterbatch may be kneaded with an ethylene copolymer for dilution and extruded to be molded. The production of the solar cell-sealing material using a masterbatch can provide a higher degree of dispersion of the laminar composite metal compound.

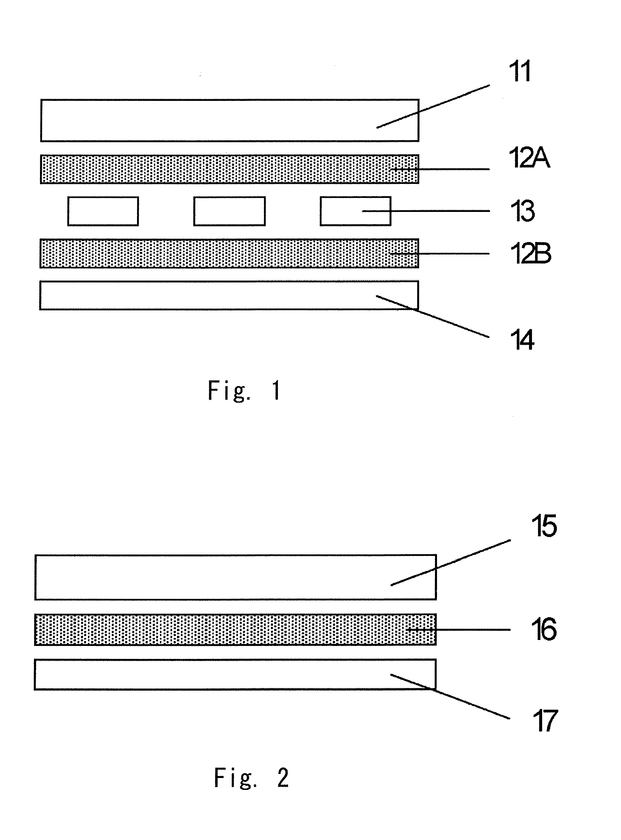

Fig. 1 is a schematic explanatory diagram showing an example of a solar cell module. In Fig. 1, reference numeral 11 denotes a transparent substrate; 12A, a front-surface solar cell-sealing material; 12B, a back-surface solar cell-sealing material; 13, electricity generating elements; and 14, a protective member. The electricity generating elements 13 are sandwiched between the front-surface solar cell-sealing material 12A and the back-surface solar cell-sealing material 12B. This laminate is sandwiched between the transparent substrate 11 and the protective member 14. The solar cell module can be produced by fixing solar cell-sealing materials to upper and lower portions of each solar cell element. The solar cell module is typically produced by heating and pressure bonding using a vacuum laminator. Examples of the structure of the solar cell module include a super straight structure in which solar cell-sealing elements are sandwiched by the solar cell-sealing materials, such as a transparent substrate/solar cell-sealing material/solar cell elements/solar cell-sealing material/protective member as shown in the example of Fig. 1, and a structure in which solar cell elements formed on the surface of a substrate are laminated with solar cell-sealing materials and a protective member, such as a structure including a transparent substrate/solar cell elements/solar cell-sealing materials/a protective member. As the transparent substrate, a thermally-tempered white glass, a transparent film, or the like is used. As the sealing material, an ethylene-vinyl acetate copolymer having an excellent moisture resistance, or the like is used. As the protective member requiring moisture-proof/insulating properties, a sheet having a structure in which aluminum is sandwiched between vinyl fluoride films, a sheet having a structure in which aluminum is sandwiched between hydrolysis resistant polyethylene terephthalate films, or the like is used.

### [Examples]

The present invention will be described further in detail in reference to examples. However, the present invention is not limited to these examples. Hereinafter, parts represent parts by weight, and % represents weight %.

(A) Ethylene copolymer

(A-1) manufactured by Tosoh Corporation (Ultrathene 751, ethylene-vinyl acetate copolymer, vinyl acetate content: 28%, MFR: 5.7)
(A-2) manufactured by Tosoh Corporation (Ultrathene 637-1, ethylene-vinyl acetate copolymer, vinyl acetate content: 20%, MFR: 8.0)
(A-3) manufactured by Du Pont-Mitsui Polychemicals Co., Ltd. (EVAFLEX V523, ethylene-vinyl acetate copolymer, vinyl acetate content: 33%, MFR: 14)

### (B) Laminar composite metal compounds and calcined products of the compounds

Table 1 shows chemical compositions of (B-1) to (B-10).
(B-11): A calcined product obtained by performing heat treatment on the laminar composite metal compound (B-1) at 550°C for three hours.
(B-12): A calcined product obtained by performing heat treatment on the laminar composite metal compound (B-3) at 400°C for four hours.
(B-13): A calcined product obtained by performing heat treatment on the laminar composite metal compound (B-4) at 650°C for two and a half hours.
(B-14): A calcined product obtained by performing heat treatment on the laminar composite metal compound (B-6) at 300°C for three and a half hours.
(B-15): A calcined product obtained by performing heat treatment on the laminar composite metal compound (B-18) at 600°C for three and a half hours.
(B-19): A calcined product obtained by performing heat treatment on the laminar composite metal compound (B-17) at 750°C for two and a half hours.

[Table 1]

**TABLE 1**

| | Mg₁₋ₐ•Alₐ(OH)₂•Anⁿ⁻_{a/n}•cH₂O | | | AVERAGE PLATE SURFACE DIAMETER (µm) | REFRACTIVE INDEX | BET SPECIFIC SURFACE AREA (m²/g) | ACETIC ACID ADSORPTION (µmol/g) | 80% WATER ABSORPTION TIME (minute) | CALCINED PRODUCT WATER ABSORPTION RATE (%) |
|---|---|---|---|---|---|---|---|---|---|
| | a | Anⁿ⁻ | c | | | | | | |
| B-1 | 0.209 | CO₃²⁻ | 0.125 | 0.02 | 1.521 | 95 | 0.65 | 93 | - |
| B-2 | 0.205 | CO₃²⁻ | 0.110 | 0.06 | 1.518 | 46 | 0.54 | 88 | - |
| B-3 | 0.215 | CO₃²⁻ | 0.245 | 0.08 | 1.525 | 41 | 0.51 | 105 | - |
| B-4 | 0.233 | CO₃²⁻ | 0.175 | 0.45 | 1.524 | 20 | 0.39 | 102 | - |
| B-5 | 0.245 | CO₃²⁻ | 0.055 | 0.19 | 1.527 | 63 | 0.62 | 99 | - |
| B-6 | 0.245 | CO₃²⁻ | 0.105 | 0.09 | 1.562 | 39 | 0.14 | 105 | - |
| B-7 | 0.215 | CO₃²⁻ | 0.210 | 0.28 | 1.530 | 10 | 0.14 | 142 | - |
| B-8 | 0.363 | CO₃²⁻ | 0.145 | 0.25 | 1.545 | 30 | 0.08 | 124 | - |
| B-9 | 0.214 | CO₃²⁻ | 2.450 | 0.10 | 1.524 | 45 | 0.23 | 140 | - |
| B-10 | 0.225 | CO₃²⁻ | 0.255 | 0.48 | 1.495 | 17 | 0.06 | 117 | - |
| B-11 | - | - | - | 0.02 | 1.668 | - | 0.73 | - | 75 |
| B-12 | - | - | - | 0.08 | 1.652 | - | 0.62 | - | 35 |
| B-13 | - | - | - | 0.50 | 1.675 | - | 0.75 | - | 47 |
| B-14 | - | - | - | 0.09 | 1.715 | - | 0.23 | - | 26 |
| B-15 | - | - | - | 0.13 | 1.685 | - | 0.15 | - | 16 |
| B-16 | 0.242 | CO₃²⁻ | 0.087 | 0.62 | 1.490 | 15 | 0.27 | 110 | - |
| B-17 | 0.261 | CO₃²⁻ | 0.525 | 0.80 | 1.505 | 7 | 0.15 | 108 | - |
| B-18 | 0.221 | CO₃²⁻ | 0.250 | 1.20 | 1.513 | 2 | 0.04 | 135 | |
| B-19 | - | - | - | 0.85 | 1.673 | - | 0.24 | - | 39 |

(C) Laminar composite metal compounds and calcined products of the compounds
Table 2 shows chemical compositions of (C-1) to (C-15).
(C-16): A calcined product obtained by performing heat treatment on the laminar composite metal compound (C-2) at 450°C for two hours.
(C-17): A calcined product obtained by performing heat treatment on the laminar composite metal compound (C-3) at 400°C for two hours.
(C-18): A calcined product obtained by performing heat treatment on the laminar composite metal compound (C-11) at 350°C for one hour.
(C-19): A calcined product obtained by performing heat treatment on the laminar composite metal compound (C-6) at 650°C for three hours.
(C-20): A calcined product obtained by performing heat treatment on the laminar composite metal compound (C-10) at 350°C for one hour.

[Table 2]

**TABLE 2**

| | (MₐMg₁₋ₐ)_{1-b}•Al_{b}(OH)₂•Anⁿ⁻_{b/n}•cH₂O | | | | | AVERAGE PLATE SURFACE DIAMETER (µ*m*) | REFRACTIVE INDEX | ACETIC ACID ADSORPTION (*µ*mol/g) |
|---|---|---|---|---|---|---|---|---|
| | M | a | b | c | Anⁿ⁻ | | | |
| C-1 | Ni | 1.00 | 0.20 | 0.10 | CO₃²⁻ | 0.08 | 1.56 | 0.52 |
| C-2 | Ni | 1.00 | 0.33 | 0.60 | CO₃²⁻ | 0.03 | 1.55 | 0.49 |
| C-3 | Ni | 0.80 | 0.20 | 0.40 | CO₃²⁻ | 0.23 | 1.53 | 0.45 |
| C-4 | Ni | 0.50 | 0.40 | 2.50 | CO₃²⁻ | 0.10 | 1.52 | 0.38 |
| C-5 | Ni | 0.30 | 0.33 | 1.00 | CO₃²⁻ | 0.05 | 1.51 | 0.62 |
| C-6 | Ni | 0.20 | 0.33 | 0.65 | CO₃²⁻ | 0.45 | 1.53 | 0.61 |
| C-7 | Ni | 0.85 | 0.35 | 0.45 | CO₃²⁻ | 0.75 | 1.54 | 0.42 |
| C-8 | Ni | 0.80 | 0.20 | 0.10 | CO₃²⁻ | 0.65 | 1.63 | 0.24 |
| C-9 | Ni | 0.05 | 0.33 | 2.00 | CO₃²⁻ | 0.12 | 1.50 | 0.27 |
| C-10 | Ni | 0.85 | 0.25 | 0.15 | CO₃²⁻ | 1.10 | 1.55 | 0.18 |
| C-11 | Zn | 1.00 | 0.33 | 3.00 | CO₃²⁻ | 0.10 | 1.52 | 0.25 |
| C-12 | Zn | 1.00 | 0.20 | 0.80 | CO₃²⁻ | 0.05 | 1.52 | 0.35 |
| C-13 | Zn | 0.50 | 0.20 | 1.20 | CO₃²⁻ | 0.12 | 1.51 | 0.53 |
| C-14 | Ca | 0.80 | 0.33 | 2.25 | CO₃²⁻ | 0.35 | 1.57 | 0.47 |
| C-15 | Zn | 1.00 | 0.33 | 2.50 | CO₃²⁻ | 1.55 | 1.56 | 0.15 |
| C-16 | - | - | - | - | - | 0.03 | 1.7 | 0.73 |
| C-17 | - | - | - | - | - | 0.2 | 1.68 | 0.65 |
| C-18 | - | - | - | - | - | 0.15 | 1.62 | 0.36 |
| C-19 | - | - | - | - | - | 0.55 | 1.66 | 0.55 |
| C-20 | - | - | - | - | - | 1.15 | 1.72 | 0.22 |

### (Example 1)

Eighty-five parts by weight of ethylene copolymer and 15 parts by weight of laminar composite metal compound were input into a super mixer (manufactured by Mitsui Mining Co., Ltd.) and were stirred for three minutes at 20°C. After that, a laminar composite metal compound masterbatch was obtained by a biaxial extruder (manufactured by Nippon Placon Co., Ltd.). Further, by the same method as that for the resin composition for solar cell-sealing material, a stabilizer masterbatch was obtained by blending 80 parts by weight of ethylene copolymer with 10 parts by weight of ultraviolet light absorber, 5 parts by weight of light stabilizer, and 5 parts by weight of antioxidant. Furthermore, a crosslinker masterbatch impregnated in the ethylene copolymer was obtained by stirring 70 parts by weight of ethylene copolymer with 15 parts by weight of crosslinker, 15 parts by weight of coagent, and 15 parts by weight of silane coupling agent, by use of the super mixer.
The ethylene copolymer (A) and the laminar composite metal compound or the calcined product of the compound were prepared by blending quantities shown in Table 3 by use of the obtained laminar composite metal compound masterbatch, stabilizer masterbatch, crosslinker masterbatch, and ethylene copolymer (A). After the preparation, the resultant was extruded to be molded by a T-die extruder at 90°C to thereby produce solar cell-sealing materials 12A, 12B, 16, 18, and 21 (having a thickness of 1.0 mm).
Note that 10 parts by weight of each of the crosslinker masterbatch and the stabilizer masterbatch were blended with 100 parts by weight in total of the ethylene copolymer and the laminar composite metal compound by blending quantities shown in Table 3. The types of the crosslinker, coagent, silane coupling agent, light stabilizer, and antioxidant are as follows:
crosslinker: 2,5-dimethyl-2,5-di(tert-butylperoxy)hexane;
coagent: triallyl isocyanurate;
silane coupling agent: γ-methacryloxypropyltrimethoxysilane;
ultraviolet light absorber: 2-hydroxy-4-methoxybenzophenone;
light stabilizer: N,N'-bis(3-aminopropyl)ethylenediamine-2,4-bis[N-butyl-N-(1,2,2,6,6-pentamethyl-4-piperidyl)amino]-6-chloro-1,3,5-triazine condensate; and
antioxidant: phenyldiisodecyl phosphite.

### (Examples 2 to 17 and Comparative Examples 1 to 13)

The solar cell-sealing materials 12A, 12B, 16, 18, and 21 were produced by preparing the resin composition for solar cell-sealing materials in the same manner as in Example 1, except for the blending quantities shown in Tables 3 and 4.

[Table 3]

**TABLE 3**

| | | EXAMPLE | | | | | | | | | | | | | | | | |
|---|---|---|---|---|---|---|---|---|---|---|---|---|---|---|---|---|---|---|
| | | 1 | 2 | 3 | 4 | 5 | 6 | 7 | 8 | 9 | 10 | 11 | 12 | 13 | 14 | 15 | 16 | 17 |
| (A) | A-1 | 99 | 97 | 95 | | | | | | | | | | | 99.8 | | | 99 |
| | A-2 | | | | 95 | | | | | 96 | 96 | 94 | 97.5 | | | 99 | | |
| | A-3 | | | | | 98 | 99.9 | 99.95 | 99.5 | | | | | 93 | | | 99.5 | |
| (B) | B-1 | 1 | | | | 2 | | | | | | | | | | | | |
| | B-2 | | 3 | | 5 | | | | | | | | | | 2 0.1 | | | |
| | B-3 | | | 5 | | | | | | | 3 | 3 | 1 | | | | | |
| | B-4 | | | | | | 0.1 | | | | | | | | | | | |
| | B-5 | | | | | | | 0.05 | | | | | | | | | | |
| | B-11 | | | | | | | | 0.5 | 4 | 1 | 3 | 1.5 | | | | | |
| | B-12 | | | | | | | | | | | | | 5 | | | | |
| | B-13 | | | | | | | | | | | | | | 0.1 | | | |
| | B-16 | | | | | | | | | | | | | | | 1 | | |
| | B-17 | | | | | | | | | | | | | | | | 0.5 | |
| | B-19 | | | | | | | | | | | | | | | | | 1 |

[Table 4]

**TABLE 4**

| | | COMPARATIVE EXAMPLE | | | | | | | | | | | | |
|---|---|---|---|---|---|---|---|---|---|---|---|---|---|---|
| | | 1 | 2 | 3 | 4 | 5 | 6 | 7 | 8 | 9 | 10 | 11 | 12 | 13 |
| (A) | A-1 | 99.5 | 98 | 95 | | | | 97 | | 95 | 98 | 97 | 98 | 100 |
| | A-2 | | | | 97 | | | | | | | | | |
| | A-3 | | | | | 99 | 96 | | 99.9 | | | | | |
| (B) | B-6 | | | 5 | | | | | | | | | | |
| | B-7 | 0.5 | | | | | 4 | | | 1 | | | | |
| | B-8 | | 2 | | | | | | | | 1 | | | |
| | B-9 | | | | 3 | | | | | | | | | |
| | B-10 | | | | | 1 | | | | | | | | |
| | B-14 | | | | | | | 3 | 0.1 | 4 | 1 | | | |
| | B-15 | | | | | | | | | | | 3 | | |
| | B-18 | | | | | | | | | | | | 2 | |

Test pieces obtained by Examples 1 to 17 and Comparative Examples 1 to 13 were evaluated basd on the following standards. The evaluation results are shown in Table 5.

### [Acid Trapping Effect]

A sample for durability test as shown in Fig. 2 was produced. First, the solar cell-sealing material 16 obtained by Examples 1 to 17 was laminated by being sandwiched between a transparent substrate (glass having a thickness of 3 mm) 15 and a protective member 17 formed of a hydrolysis resistant polyethylene terephthalate film (having a thickness of 0.1 mm). Then, under vacuum conditions in a vacuum laminator, the laminate was subjected to heating and pressure bonding at 150°C for 35 minutes to crosslink the sealing material, thereby producing a sample (1) for durability test. Further, a laminate shown in Fig. 2 was produced. Under vacuum conditions in a vacuum laminator, the laminate was subjected to heating and pressure bonding at 150°C for 15 minutes. After that, the sealing material was crosslinked in an oven at 150°C for 15 minutes, thereby producing a sample (2) for durability test. An acid generation rate in the sample (2) for durability test was accelerated by an aceclerated test, and then the amount of generated acid was measured.

The accelerated test was carried out by a pressure cooker test. The sample (1) for durability test was tested under an environment where the temperature was 121 °C, the humidity was 100% RH, and the pressure was 2 of kg/cm² in a static condition for 72 hours. After that, 5.0 g of solar cell-sealing material was dipped in 5.0 ml of acetone at 25°C for 48 hours, and the amount of acetic acid contained in the acetone extract was determined by gas chromatography (Acid Trapping Effect 1). Further, under the same conditions, an accelerated test for the sample (2) for durability test was carried out. After that, 1.5 g of solar cell-sealing material was dipped in 10 ml of purified water at 25°C for 24 hours. Then, the resultant was placed in an ultrasound bath for 10 minutes, and the amount of acetic acid contained in the water extract was determined by ion chromatography (Acid Trapping Effect 2).

### [Transparency]

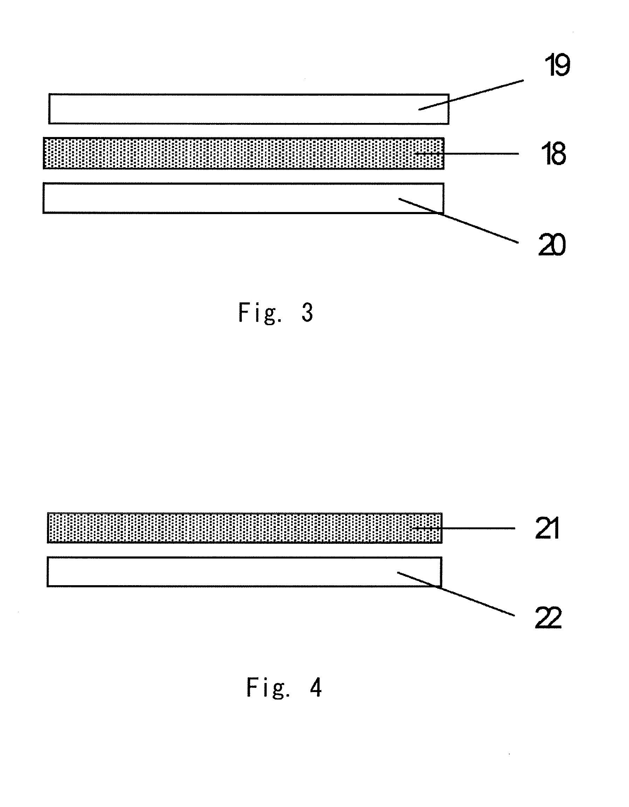

As shown in Fig. 4, the solar cell-sealing material 21 obtained by Examples 1 to 17 and Comparative Examples 1 to 13 and a protective member 22 formed of a hydrolysis resistant polyethylene terephthalate film (having a thickness of 0.1 mm) were laminated in two layers. After that, under vacuum conditions in a vacuum laminator, the laminate was heated at 150°C for 35 minutes to crosslink the sealing material, thereby producing a sample (3) for durability test. Haze values obtained before and after the durability test were measured by a haze meter manufactured by BYK Gardner.

The accelerated test was carried out by a pressure cooker test. The sample for durability test was tested under an environment where the temperature was 121°C, the humidity was 100% RH, and the pressure was 2 kg/cm² in a static condition for 48 hours.

### [Peel Strength]

As shown in Fig. 4, the solar cell-sealing material 21 obtained by Examples 1 to 17 and Comparative Examples 1 to 13 and the protective member 22 formed of a hydrolysis resistant polyethylene terephthalate film (having a thickness of 0.1 mm) were laminated in two layers. After that, under vacuum conditions in a vacuum laminator, the laminate was heated at 150°C for 35 minutes to crosslink the sealing material, thereby producing a sample (4) for durability test. Adhesive properties with respect to the protective member obtained before and after the durability test were measured by a peel strength in a peeling test.

The durability test was carried out by a pressure cooker test. The sample for durability test was tested under an environment where the temperature was 121°C, the humidity was 100% RH, and the pressure was 2 kg/cm² in a static condition for 48 hours.

The peel strength between the sealing material and the protective member was measured such that a test piece was prepared by cutting out a strip of film with a width of 25 mm from the sample for durability test film and a peeling test was conducted using a tensile tester under a tension condition of 50 mm/min at 180°.

### [Standard Retention Rate]

The electricity generating elements were sandwiched between the solar cell-sealing materials 12A and 12B obtained by Examples 1 to 17 and Comparative Examples 1 to 13. The resultant was sandwiched between the transparent substrate (glass having a thickness of 3 mm) 11 and the protective member 14 including three layers (having a thickness of 1.0 mm) of hydrolysis resistant polyethylene terephthalate/aluminum/hydrolysis resistant polyethylene terephthalate, as shown in Fig. 1, thereby forming a laminate. Then, under vacuum conditions in a vacuum laminator, the laminate was heated at 150°C for 40 minutes to crosslink the sealing material, thereby producing the sample 1. A test was conducted on the sample 1 using a thermo-hygrostat tester under an environment of 85°C and 85% RH in a static condition for 1000 hours. A conversion efficiency was calculated based on entering light energy, an output at an optimum operating point, and areas of the electricity generating elements. An evaluation was made assuming that an initial conversion efficiency of a reference sample produced by removing the laminar composite metal compound from the sample 1 was 100. A conversion efficiency obtained after the test for the sample 1 with respect to the initial conversion efficiency was determined as a standard retention rate.

### [Conversion Efficiency Retention Rate]

The electricity generating elements were sandwiched between the solar cell sealing materials 12A and 12B obtained by Examples 1 to 17 and Comparative Examples 1 to 13. The resultant was sandwiched between the transparent substrate (glass having a thickness of 3 mm) 11 and the protective member 14 including three layers (having a thickness of 1.0 mm) of hydrolysis resistant polyethylene terephthalate/aluminum/hydrolysis resistant polyethylene terephthalate, as shown in Fig. 1, thereby forming a laminate. Then, under vacuum conditions in a vacuum laminator, the laminate was subjected to heating and pressure bonding at 150°C for 15 minutes. After that, the sealing material was crosslinked in an oven at 150°C for 15 minutes, thereby forming the sample 2. A test was conducted on the sample 2 using a pressure cooker tester under an environment where the temperature was 121 °C, the humidity was 100% RH, and the pressure was 2 kg/cm² in a static condition for 72 hours. A conversion efficiency was calculated based on entering light energy, an output at an optimum operating point, and areas of the elctricity generating elements. An evaluation was made assuming that the conversion efficiency of a single electricity generating element was 100. A conversion efficiency obtained before the test for the sample 2 with respect to the conversion efficiency of a single electricity generating element was determined as an initial conversion efficiency retention rate. A conversion efficiency obtained after the test of the sample 2 with respect to the conversion efficiency of a single electricity generating element was determined as an aging conversion efficiency retention rate.

[Table 5]

**TABLE 5**

| | | ACID TRAPPING EFFECT 1 | ACID TRAPPING EFFECT 2 | TRANSPARENCY (HAZE VALUE) | | PEEL STRENGTH (kg/25mm) | | STANDARD RETENTION RATE | CONVERSION EFFICIENCY RETENTION RATE | |
|---|---|---|---|---|---|---|---|---|---|---|
| | | ACETIC ACID AMOUNT (ppm) | ACETIC ACID AMOUNT(ppm) | BEFORE TEST | AFTER TEST | BEFORE TEST | AFTER TEST | (%) | INITIAL (%) | TIME ELAPSED(%) |
| | 1 | 486 | 164 | 0.81 | 4.11 | 12.5 | 11.6 | 96.6 | 100.38 | 97.93 |
| | 2 | 312 | 122 | 2.68 | 4.76 | 12.3 | 11.6 | 97.4 | 100.71 | 98.33 |
| | 3 | 220 | 87 | 2.29 | 3.12 | 12.1 | 11.9 | 97.8 | 100.22 | 98.39 |
| | 4 | 275 | 93 | 4.12 | 6.20 | 12.4 | 12.1 | 98.0 | 100.29 | 98.15 |
| | 5 | 390 | 111 | 3.77 | 5.45 | 12.2 | 11.7 | 98.1 | 100.78 | 98.42 |
| | 6 | 549 | 205 | 1.23 | 5.19 | 12.1 | 11.4 | 97.3 | 100.17 | 98.02 |
| | 7 | 563 | 194 | 1.31 | 5.63 | 11.9 | 11.6 | 97.1 | 100.21 | 97.89 |
| | 8 | 544 | 203 | 0.93 | 4.56 | 12.5 | 11.5 | 97.2 | 100.48 | 98.13 |
| EXAMPLE | 9 | 158 | 66 | 5.82 | 6.45 | 12.1 | 12.0 | 97.2 | 100.62 | 98.11 |
| | 10 | 330 | 106 | 4.12 | 5.78 | 12.3 | 12.2 | 98.7 | 100.65 | 98.57 |
| | 11 | 189 | 75 | 5.73 | 5.99 | 11.9 | 11.8 | 97.7 | 100.84 | 98.2 |
| | 12 | 195 | 69 | 5.61 | 6.13 | 11.9 | 11.6 | 97.6 | 101.13 | 98.04 |
| | 13 | 128 | 58 | 5.98 | 6.31 | 11.8 | 11.6 | 96.9 | 100.88 | 98.35 |
| | 14 | 399 | 157 | 3.66 | 4.80 | 12.1 | 11.9 | 97.4 | 100.37 | 98.15 |
| | 15 | 474 | 187 | 3.19 | 5.99 | 12.1 | 11.3 | 96.78 | 100.22 | 97.89 |
| | 16 | 221 | 74 | 3.82 | 5.11 | 12.2 | 11.9 | 97.9 | 100.53 | 98.31 |
| | 17 | 272 | 88 | 5.21 | 6.06 | 12.0 | 11.7 | 96.9 | 100.31 | 98.29 |
| | 1 | 1836 | 518 | 5.72 | 14.9 | 12.3 | 6.5 | 92.1 | 99.77 | 95.15 |
| | 2 | 1788 | 522 | 7.99 | 13.9 | 11.9 | 7.7 | 92.7 | 99.65 | 95.44 |
| | 3 | 1550 | 449 | 8.55 | 13.1 | 12.1 | 8.6 | 93.2 | 99.73 | 95.89 |
| | 4 | 1732 | 482 | 8.69 | 12.7 | 12.6 | 7.9 | 92.2 | 99.45 | 96.02 |
| | 5 | 1813 | 495 | 7.64 | 13.8 | 12.0 | 7.3 | 91.8 | 99.77 | 95.73 |
| COMPARATIVE | 6 | 1758 | 472 | 9.02 | 11.3 | 12.3 | 7.3 | 93.3 | 99.73 | 95.49 |
| EXAMPLE | 7 | 1592 | 472 | 11.2 | 12.9 | 12.3 | 8.4 | 93.7 | 99.54 | 95.14 |
| | 8 | 1897 | 535 | 6.11 | 14.5 | 12.1 | 6.9 | 92.3 | 99.8 | 95.89 |
| | 9 | 1470 | 421 | 11.6 | 12.6 | 12.4 | 8.9 | 93.8 | 99.71 | 96.12 |
| | 10 | 1683 | 493 | 8.76 | 11.5 | 12.0 | 8.2 | 92.5 | 99.79 | 95.88 |
| | 11 | 1459 | 397 | 8.7 | 9.4 | 11.9 | 8.8 | 93.5 | 99.72 | 96.25 |
| | 12 | 1794 | 486 | 8.24 | 13.8 | 12.4 | 6.8 | 92.6 | 99.71 | 95.24 |
| | 13 | >5000 | 789 | 0.45 | 23.4 | 12.5 | 4.3 | 88.7 | 99.23 | 94.38 |

From the results shown in Table 5, Examples 1 to 17 showed physical properties more excellent than those of Comparative Examples in every evaluation item. Particularly, by the use of a specific laminar composite metal compound or a calcined product of the compound, such a remarkable result was obtained that the initial conversion efficiency was more improved than the case where the laminar composite metal compound was not used.

### (Example 18)

Eighty-five parts by weight of ethylene copolymer and 15 parts by weight of laminar composite metal compound were put into a super mixer (manufactured by Mitsui Mining Co., Ltd.) and were stirred for 3 minutes at 20°C. After that, a laminar composite metal compound masterbatch was obtained by a biaxial extruder (manufactured by Nippon Placon Co., Ltd.). Further, a crosslinker masterbatch was obtained by blending an ethylene copolymer with a crosslinker, a coagent, and a silane coupling agent, and a stabilizer masterbatch was obtained by blending an ethylene copolymer with an ultraviolet light absorber, a light stabilizer, and an antioxidant.
The ethylene copolymer (A) and the laminar composite metal compound or the calcined product of the compound were prepared by blending quantities shown in Table 6 by use of the obtained laminar composite metal compound masterbatch, crosslinker masterbatch, stabilizer masterbatch, and ethylene copolymer. After the preparation, the resultant was extruded to be molded by a T-die extruder at 90°C, thereby producing the solar cell-sealing materials 12A and 12B, 16, 18, and 21 (having a thickness of 0.5 mm).
The types and addition amounts of the crosslinker, coagent, silane coupling agent, ultraviolet light absorber, light stabilizer, and antioxidant contained in the solar cell-sealing materials were determined with respect to 100 parts by weight in total of the ethylene copolymer and the laminar composite metal compound as follows:
crosslinker: 0.5 parts by weight of 2,5-dimethyl-2,5-di(tert-butylperoxy)hexane;
coagent: 0.5 parts by weight of triallyl isocyanurate;
silane coupling agent: 0.5 parts by weight of γ-methacryloxypropyltrimethoxysilane;
ultraviolet light absorber: 0.25parts by mass of 2-hydroxy-4-methoxybenzophenone;
light stabilizer: 0.5 parts by mass of N,N'-bis(3-aminopropyl)ethylenediamine-2,4-bis[N-butyl-N-(1,2,2,6,6-pentamethyl-4-piperidyl)amino]-6-chloro-1,3,5-triazine condensate; antioxidant: 0.25parts by mass of phenyldiisodecyl phosphite.

### (Examples 19 to 37 and Comparative Examples 14 to 23)

The solar cell-sealing materials 12A, 12B, 16, 18, and 21 were produced by preparing the resin composition for solar cell-sealing material in the same manner as in Example 18, except for the blending quantities shown in Tables 6 and 7.

[Table 6]

**TABLE 6**

| | | EXAMPLE | | | | | | | | | | | | | | | | | | |
|---|---|---|---|---|---|---|---|---|---|---|---|---|---|---|---|---|---|---|---|---|
| | | 18 | 19 | 20 | 21 | 22 | 23 | 24 | 25 | 26 | 27 | 28 | 29 | 30 | 31 | 32 | 33 | 34 | 35 | 36 |
| (A) | A-1 | 99.5 | 98 | 95 | | | | 99 | 99.95 | | 98 | 98 | | | 99 | 97 | 99 | 97 | 97 | |
| | A-2 | | | | 98 | 96 | 99 | | | 99.5 | | | 97 | 99 | | | | | | 99.9 |
| (C) | C-1 | 0.5 | 2 | | | | | | | | | | | | | | | | | |
| | C-2 | | | 5 | | | | | | | | | | | | | | 2 | 1 | |
| | C-3 | | | | 2 | | | | | | | | | | | | | | | |
| | C-4 | | | | | 4 | | | | | | | | | | | | | | |
| | C-5 | | | | | | 1 | | | | | | | | | | | | | |
| | C-6 | | | | | | | 1 | 0.05 | | | | | | | | | | | 0.05 |
| | C-7 | | | | | | | | | 0.5 | | | | | | | | | | |
| | C-11 | | | | | | | | | | 2 | | | | | | | | | |
| | C-12 | | | | | | | | | | | 2 | | | | | | | | |
| | C-13 | | | | | | | | | | | | 3 | | | | | | | |
| | C-14 | | | | | | | | | | | | | 1 | | | | | | |
| | C-16 | | | | | | | | | | | | | | 1 | | | 1 | | |
| | C-17 | | | | | | | | | | | | | | | 3 | | | | |
| | C-18 | | | | | | | | | | | | | | | | 1 | | 2 | |
| | C-19 | | | | | | | | | | | | | | | | | | | 0.05 |

[Table 7]

**TABLE 7**

| | | COMPARATIVE EXAMPLE | | | | | | | | |
|---|---|---|---|---|---|---|---|---|---|---|
| | | 14 | 15 | 16 | 17 | 18 | 19 | 20 | 21 | 22 |
| (A) | A-1 | 98 | 95 | | 99 | | 99.95 | 99.5 | 98 | 100 |
| | A-2 | | | 97 | | 98 | | | | |
| (C) | C-8 | 2 | 5 | 3 | | | | | | |
| | C-9 | | | | 1 | 2 | | | | |
| | C-10 | | | | | | 0.05 | | | |
| | C-15 | | | | | | | 0.5 | | |
| | C-20 | | | | | | | | 2 | |

An evaluation on each of test pieces obtained by Examples 18 to 36 was made. The evaluation results are shown in Table 8.

### [Acid Trapping Effect]

A sampled for durability test as shown in Fing. 2 was produced. First, the solar cell-sealing material 16 obtained by Examples 18 to 36 and Comparative Examples 14 to 23 was sandwiched between the transparent substrate (glass having a thickness of 3 mm) 15 and the protective member 17 formed of a hydrolysis resistant polyethylene terephthalate film (having a thickness of 0.1 mm), thereby forming a laminate. After that, under vacuum conditions in a vacuum laminator, the laminate was subjected to heating and pressure bonding at 150°C for 15 minutes. Then, the sealing material was crosslinked in an oven at 150°C for 15 minutes, thereby producing the sample for durability test. Further, the acid generation rate was accelerated by an accelerated test, and then the amount of generated acid was measured.

The accelerated test was carried out by a pressure cooker test. The sample for durability test was tested under an environment where the temperature was 121°C, the humidity was 100% RH, and the pressure was 2 kg/cm² in a static condition for 72 hours. After that, 2 g of solar cell-sealing material was dipped in 10 ml of purified water at 25°C for 24 hours, and the amount of acetic acid contained in the water extract was determined by ion chromatography.

### [Transparency]

The solar cell-sealing material 18 obtained by Examples 18 to 36 and Comparative Examples 14 to 23 was sandwiched between transparent substrates (glasses each having a thickness of 3 mm) 19 and 20, thereby forming three layers (see Fig. 3). After that, under vacuum conditions in a vacuum laminator, the laminate was subjected to heating and pressure bonding at 150°C for 15 minutes. Then, the sealing material was crosslinked in an oven at 150°C for 15 minutes, thereby producing the sample for durability test. Haze values obtained before and after the accelerated test were measured by a haze meter manufactured by BYK Gardner.

The accelerated test was carried out by a pressure cooker test. The sample for durability test was tested under an environment where the temperature was 121 °C, the humidity was 100% RH, and the pressure was 2 kg/cm² in a static condition for 96 hours.

### [Peel Strength Retention Rate]

As shown in Fig. 4, the solar cell-sealing material 21 obtained by Examples 18 to 36 and Comparative Examples 14 to 23 and the protective member 22 formed of a hydrolysis resistant polyethylene terephthalate film (having a thickness of 0.1 mm) were laminated in two layers. Then, under vacuum conditions in a vacuum laminator, the laminate was subjected to heating and pressure bonding at 150°C for 15 minutes, and was then held in an oven at 150°C for 15 minutes to crosslink the sealing material, thereby producing the sample for durability test. The adhesion properties between the solar cell-sealing material and the protective member after the durability test were measured by a peeling test.

The durability test was conducted on the sample for durability test under an environment of a temperature of 85°C and a humidity of 85% RH for 500 hours in a static state.

The peel strength between the solar cell-sealing material and the protective member was measured such that a test piece was prepared by cutting out a strip of film with a width of 25 mm from the sample for durability test film and a peeling test was conducted on the test piece using a tensile tester under a tension condition of 50 mm/min at 180°. The peel strength retention rate showed the peel strength obtained after the durability test, assuming that the peel strength of the sample for durability test obtained before the durability test in Comparative Example 7, in which the laminar composite metal compound is not blended, was 100.

### [Standard Retention Rate]

The electricity generating elements were sandwiched between the solar cell-sealing materials 12A and 12B obtained by Examples 18 to 36 and Comparative Examples 14 to 23. The resultant was sandwiched between the transparent substrate (glass having a thickness of 3 mm) 11 and the protective member 14 including three layers (having a thickness of 1.0 mm) of hydrolysis resistant polyethylene terephthalate/aluminum/hydrolysis resistant polyethylene terephthalate as shown in Fig. 1, thereby forming a laminate. Then, under vacuum conditions in a vacuum laminator, the laminate was subjected to heating and pressure bonding at 150°C for 15 minutes. After that, the laminate was held in an oven at 150°C for 15 minutes to crosslink the sealing material, thereby producing a solar cell module sample. A test was conducted under an environment of 85°C and 85% RH for 1000 hours in a static condition.
A conversion efficiency was calculated based on entering light energy, an output at an optimum operating point, and areas of the elctricity generating elements. An evaluation was made assuming that the initial conversion efficiency of the reference sample produced by removing the laminar composite metal compound from the sample was 100. A conversion efficiency obtained after the test for the sample with respect to the initial conversion efficiency was determined as a standard retention rate.

### [Conversion Efficiency Retention Rate]

The electricity generating elements were sandwiched between the solar cell-sealing materials 12A and 12B obtained by Examples 18 to 36 and Comparative Examples 14 to 23. The resultant was sandwiched between the transparent substrate (glass having a thickness of 3 mm) 11 and the protective member 14 including three layers (having a thickness of 1.0 mm) of hydrolysis resistant polyethylene terephthalate/aluminum/hydrolysis resistant polyethylene terephthalate, as shown in Fig. 1, thereby forming a laminate. Then, under vacuum conditions in a vacuum laminator, the laminate was subjected to heating and pressure bonding at 150°C for 15 minutes. After that, the sealing material was crosslinked in an oven at 150°C for 15 minutes, thereby producing a solar cell module sample. A test was conducted on the sample using a pressure cooker tester under an environment where the temperature was 121 °C, the humidity was 100% RH, and the pressure was 2kg/cm² in a static condition for 72 hours. The conversion efficiency was calculated based on entering light energy, an output at an optimum operating point, and areas of the electricity generating elements.
An evaluation was made assuming that the conversion efficiency of a single electricity generating element was 100. A conversion efficiency obtained before the test for the sample 2 with respect to the conversion efficiency of a single electricity generating element was determined as an initial conversion efficiency retention rate. A conversion efficiency obtained after the test of the sample 2 with respect to the conversion efficiency of a single electricity generating element was determined as an aging conversion efficiency retention rate.

[Table 8]

**TABLE 8**

| | | ACID TRAPPING EFFECT | TRANSPARENCY (HAZE VALUE) | | RELATIVE PEEL STRENGTH | STANDARD RETENTION RATE (%) | CONVERSION EFFICIENCY RETENTION RATE | |
|---|---|---|---|---|---|---|---|---|
| | | ACID GENERATION AMOUNT (ppm) | BEFORE TEST | AFTER TEST | | | INITIAL (%) | TIME ELAPSED (%) |
| | 18 | 138 | 2.3 | 12.9 | 108 | 92.6 | 100.33 | 97.83 |
| | 19 | 84 | 4.8 | 11.9 | 111 | 95.2 | 101.05 | 97.91 |
| | 20 | 79 | 9.1 | 9.4 | 113 | 97 | 100.12 | 98.16 |
| | 21 | 90 | 3.9 | 12.2 | 115 | 95.7 | 100.28 | 98.10 |
| | 22 | 99 | 7.5 | 9.9 | 111 | 94.9 | 100.94 | 98.11 |
| | 23 | 151 | 2.9 | 14.1 | 104 | 92.1 | 100.85 | 97.69 |
| | 24 | 148 | 3.5 | 14.2 | 106 | 93.3 | 100.37 | 97.77 |
| | 25 | 152 | 3.1 | 15.4 | 106 | 94.3 | 100.29 | 97.83 |
| | 26 | 136 | 4.0 | 13.8 | 103 | 93.7 | 100.39 | 97.94 |
| EXAMPLE | 27 | 104 | 5.7 | 12.3 | 108 | 94.3 | 100.42 | 98.18 |
| | 28 | 110 | 6.6 | 12.6 | 106 | 93.8 | 100.55 | 98.05 |
| | 29 | 93 | 7 | 11.4 | 112 | 96 | 100.22 | 98.22 |
| | 30 | 114 | 3.8 | 12.9 | 110 | 94.2 | 100.47 | 98.01 |
| | 31 | 118 | 10 | 8.8 | 106 | 93.5 | 100.64 | 97.87 |
| | 32 | 71 | 13 | 6.8 | 118 | 97.3 | 101.32 | 98.42 |
| | 33 | 124 | 10.5 | 8.5 | 110 | 93 | 100.59 | 98.02 |
| | 34 | 65 | 12.6 | 7.7 | 120 | 97.8 | 100.76 | 98.27 |
| | 35 | 55 | 12.9 | 7.2 | 120 | 98.1 | 100.69 | 98.33 |
| | 36 | 115 | 7.9 | 10.2 | 113 | 95.5 | 100.53 | 98.15 |
| | 14 | 496 | 9.3 | 40.4 | 95 | 86.3 | 99.31 | 94.88 |
| | 15 | 374 | 12.1 | 29.3 | 102 | 90.2 | 99.73 | 95.94 |
| | 16 | 416 | 7.3 | 33.4 | 97 | 88.5 | 99.58 | 94.74 |
| COMPARATIVE | 17 | 448 | 4.4 | 38.9 | 100 | 89.3 | 99.77 | 95.42 |
| EXAMPLE | 18 | 469 | 5.3 | 30.1 | 93 | 85.1 | 99.16 | 94.70 |
| | 19 | 562 | 4.3 | 32.1 | 97 | 87.3 | 99.33 | 95.28 |
| | 20 | 613 | 2.9 | 37.3 | 95 | 85.4 | 99.27 | 94.79 |
| | 21 | 486 | 8.1 | 25.3 | 98 | 89.5 | 99.39 | 95.19 |
| | 22 | 387 | 2.5 | 26.9 | 100 | 91.4 | 99.43 | 94.41 |

From the results shown in Table 8, compared with Comparative Examples, the solar cell-sealing materials using the resin compositions for solar cell-sealing materials obtained by Examples 18 to 36 of the present invention are improved in the initial conversion efficiency when they are formed into a module. Furthermore, controlling the quantities of the metal compositions and the average plate surface diameter of each of the laminar composite metal compounds enables maintenance of the transparency and reduction in filler activity. Moreover, degradation in the adhesion properties with respect to the protective member over time and degradation in the conversion efficiency can be inhibited due to high acid/water trapping effects.

This application is based upon and claims the benefit of priority from Japanese patent application No. 2009-185273, filed on August 7, 2009, Japanese patent application No. 2010-6380, filed on January 15, 2010, and Japanese patent application Nos. 2010-131566 and 2010-131567, filed on June 9, 2010, the disclosure of which is incorporated herein in its entirety by reference.

### Reference Signs List

- 11: TRANSPARENT SUBSTRATE
- 12A: FRONT-SURFACE SOLAR CELL-SEALING MATERIAL
- 12B: BACK-SURFACE SOLAR CELL-SEALING MATERIAL
- 13: ELECTRICITY GENERATING ELEMENT
- 14: PROTECTIVE MEMBER
- 15: TRANSPARENT SUBSTRATE
- 16: SEALING MATERIAL
- 17: PROTECTIVE MEMBER
- 18: SEALING MATERIAL
- 19: TRANSPARENT SUBSTRATE
- 20: TRANSPARENT SUBSTRATE
- 21: SEALING MATERIAL
- 22: PROTECTIVE MEMBER

## Claims

1. A resin composition for solar cell-sealing material including an ethylene copolymer (A), the resin composition comprising at least one of:
(i) a laminar composite metal compound represented by the following general formula (1);
(ii) a calcined product of the laminar composite metal compound represented by the general formula (1);
(iii) a laminar composite metal compound represented by the following general formula (2); and
(iv) a calcined product of the laminar composite metal compound represented by the general formula (2),
wherein the (i) has an average plate surface diameter of 0.01 µm to 0.9 µm and a refractive index of 1.45 to 1.55, and
wherein the (iii) has an average plate surface diameter of 0.02 µm to 0.9 µm and a refractive index of 1.48 to 1.6,
the general formula (1): Mg₁₋ₐ·Alₐ(OH)₂·Anⁿ⁻_{a/n}·bH₂O
(0.2≤a≤0.35, 0≤b≤1, An: an n-valent anion),
the general formula (2): (M_{c}Mg_{g1-c})_{1-d}·Al_{d}(OH)₂·Bm^{m-}_{d/m}·eH₂O
(M represents a metal selected from the group consisting of Ni, Zn, and Ca; c, d, and e are respectively expressed as 0.2≤c≤1, 0.2≤d≤0.4, and 0≤e≤4; Bm: an m-valent anion).

2. The resin composition for solar cell-sealing material according to Claim 1, wherein each of the (i) to (iv) has an acetic acid adsorption of 0.1 µmol/g to 0.8 µmol/g.

3. The resin composition for solar cell-sealing material according to Claim 1 or 2, wherein the (ii) is a calcined product obtained by performing heat treatment on the (i) in a temperature range of 200°C to 800°C, and the (iv) is a calcined product obtained by performing heat treatment on the (iii) in a temperature range of 200°C to 800°C.

4. The resin composition for solar cell-sealing material according to any one of Claims 1 to 3, wherein 0.01 parts by weight to 20 parts by weight of at least one compound selected from the group consisting of the (i) to (iv) are used for 100 parts by weight of the ethylene copolymer (A).

5. The resin composition for solar cell-sealing material according to any one of Claims 1 to 4, wherein a time period required for the (i) to reach 80% of an equilibrium adsorption under an environment of 23°C and 50% RH is 120 minutes or less.

6. The resin composition for solar cell-sealing material according to any one of Claims 1 to 5, wherein the (ii) has a refractive index of 1.59 to 1.69, and a water absorption rate of 10% to 85% under an environment of 23°C and 50% RH in a stationary state for 2000 hours.

7. The resin composition for solar cell-sealing material according to any one of Claims 1 to 6, wherein the (i) has a BET specific surface area of 5 m²/g to 200 m²/g.

8. The resin composition for solar cell-sealing material according to any one of Claims 1 to 7, wherein the (iv) has an average plate surface diameter of 0.02 µm to 0.9 µm and a refractive index of 1.58 to 1.72.

9. The resin composition for solar cell-sealing material according to any one of Claims 1 to 8, wherein the ethylene copolymer (A) is at least one copolymer selected from the group consisting of an ethylene-vinyl acetate copolymer, an ethylene-methyl acrylate copolymer, an ethylene-ethyl acrylate copolymer, an ethylene-methyl methacrylate copolymer, and an ethylene-ethyl methacrylate copolymer.

10. A masterbatch comprising a resin composition for solar cell-sealing material according to any one of Claims 1 to 9.

11. A solar cell-sealing material comprising a mixture including a resin composition for solar cell-sealing material according to any one of Claims 1 to 9.

12. A solar cell module comprising a resin composition for solar cell-sealing material according to any one of Claims 1 to 9.
